# EUROPEAN PATENT SPECIFICATION

(11) **EP 0 987 599 B1**
(45) Date of publication and mention of the grant of the patent: **05.05.2010**
(21) Application number: 99116826.1
(22) Date of filing: 02.09.1999
(51) Int. Cl.: G03F 7/00, B42D 15/00

(54) **High-definition printing process, particularly for security strips for currency bills and the like**
Hochauflösendes Druckverfahren, insbesondere für Sicherheitsmarkierungen auf Banknoten und dergleichen
Procédé d'impression à haute résolution, particulièrement pour des marques fiduciaires sur billets de banque et similaire

(30) Priority: 16.09.1998 IT MI982016
(43) Date of publication of application: 22.03.2000
(73) Proprietor: FABRIANO SECURITIES S.R.L., 38062 Arco (Trento) (IT)
(72) Inventor: Lazzerini, Maurizio, 20070 Cerro al Lambro (Milano) (IT)
(74) Representative: Modiano, Micaela Nadia

(56) References cited:
- EP-A- 0 365 031
- EP-A- 0 536 855
- GB-A- 1 394 747
- GB-A- 2 319 215
- US-A- 4 941 687
- US-A- 5 622 794

## Description

The present invention relates to a high-definition printing process, particularly for security strips for currency bills and the like.

It is known that the use of security strips meant to prevent forgery of items of various kinds is increasingly widespread.

The most common example is constituted by currency bills, in which a security strip is inserted on which characters or distinctive markings are inscribed, making reproduction difficult for potential forgers.

Currency note forgery is one of the problems whose solution has included field-specific studies aimed at devising innovative printing processes which allow to minimize the possibilities of reproducing currency bills by inserting security strips in the currency bills.

The security strips currently used for currency bills are likewise used for passports, credit cards, food packages and the like.

Forgery of food packages of well-known brands is in fact also frequent in the field of food packaging. Such forgeries can be greatly limited by including said security strips in the package.

Conventional methods for printing security strips are generally so-called offset printing, rotogravure printing, or relief printing.

In the first case, printing occurs with a flat plate, while in the second and third cases printing occurs respectively with etched and relief plates.

Transfer of the ink onto the surface to be printed is difficult to perform, since the ink tends to spread due to compression and the edges of the characters are therefore not perfectly sharp.

Accordingly, conventional printing processes lead to the printing of characters whose dimensions necessarily cannot be smaller than a certain limit, beyond which said characters arc highly affected by lack of definition.

Therefore, also in security strips provided in currency bills, on which the characters or symbols are printed, it is necessary not to go beyond a certain level of miniaturization of the character, since otherwise it is substantially impossible to achieve good definition of the character, accordingly making it no longer possible to discriminate between an authentic currency bill and a forged one.

GB-A-2 319 215 discloses a method as defined in the preamble of claims 1 and 2.

US-A- 4941 687 discloses a security paper for currency and bank notes, and a method.

The aim of the present invention is to provide a high-definition printing process, particularly for security strips for currency bills and the like.

Within the scope of this aim, an object of the present invention is to provide a high-definition printing process, particularly for security strips for currency bills and the like, which can be performed continuously and in which the size of the character is greatly miniaturized with respect to normally obtainable sizes, and with good definition.

Another object of the present invention is to provide a high-definition printing process, particularly for security strips for currency bills and the like, which allows to apply graphic markings with separations and without any deformation both by means of a cylinder and by means of a flat plate.

Another object of the present invention is to provide a high-definition printing process, particularly for security strips for currency bills and the like, in which the process has a shorter duration than conventional printing processes.

Another object of the present invention is to provide a high-definition printing process which can also be used in providing flexible packaging in which it is necessary to print security microcharacters, for providing holographic images, for flexible packaging provided with miniaturized partial demetallizations and the like.

Another object of the present invention is to provide a high-definition printing process, particularly for security strips for currency bills and the like, which is highly reliable, relatively easy to perform and at competitive costs.

This aim, these objects and others which will become apparent hereinafter are achieved by a high-definition printing process, particularly for security strips for currency bills and the like, as defined in independent claims 1 and 2.

Further characteristics and advantages of the present invention will become apparent from the description of preferred embodiments of the method according to the invention.

In particular, the method according to the invention provides for a first step in which a substrate, for example in the form of a tape of transparent and/or opaque material, such as for example a plastics such as polyester, polypropylene, PVC, etcetera, is treated by vacuum metallization.

A deposition step is performed on the substrate thus metallized in order to deposit, by means of a printing process using rotogravure, spreading, screenprinting, spraying, coating and the like, a lacquer having a solvent base (for example ethyl acetate) with characteristics that provide filming and adhesion to the substrate after evaporation, changing of the state of the lacquer by means of ultraviolet rays with a photoinitiator and the characteristic of being able to be selectively saponified according to the pattern of the printing masking element, with sodium carbonate in a percentage between 0.4 and 2%, preferably 0.6 to 1% (even more preferably 0.7%), subsequently treated with a spray of the sodium carbonate solution.

The temperature at which the above-described step occurs is preferably in the range between 20 and 60 degrees Celsius; it has been found that the optimum temperature is around 40 degrees Celsius.

The substrate is then washed in water and dried.

The substrate can be treated in this manner continuously, being unwound from the reels on which it is arranged.

The printing masking element is arranged above the metallized substrate covered with the solvent-based lacquer and is transparent only in the regions where the lacquer is meant to change state.

The change of state of the lacquer (i.e., a particular chemical bond between the molecules of the lacquer that does not allow said lacquer to be attacked by a removal means) is performed by exposure to ultraviolet rays.

The exposure time of course varies according to the type of lacquer used, to the speed at which the substrate unwinds continuously from the corresponding reels, to the thickness of said lacquer and of course to the power of the light source.

Once the lacquer has changed state, it can no longer be removed, whereas in the regions in which the masking element is not transparent the change of state does not occur and it is therefore possible to remove the lacquer.

In this case, the removed lacquer can no longer act as a protection for the underlying metallization.

The resulting film (polyester with vacuum metallization, protected in the regions where the ultraviolet-sensitive lacquer has changed state) is then introduced in a tank with a bath of phosphoric acid in a percentage between 30 and 70%, more preferably 40%, and brought to a temperature between 30 to 80°, more preferably 55°C.

The immersion time in the phosphoric acid bath varies from 3 seconds to over 1 minute.

The substrate is then washed in demineralized water, subsequently immersed in a bath of water and ammonia in order to buffer the effect of the acid and finally washed again with demineralized water.

The high definition of the graphic markings is achieved by providing perfect contact of the substrate with its masking element (which is negative or positive and is provided for continuous exposure both with the cylinder method and with the plate method). Since the lacquer is light-sensitive, its sensitization occurs by exposing the composite to the ultraviolet rays emitted by the lamp, which is arranged inside the cylinder for the cylinder method and below or above the plate for the plate method, so that the lacquer is struck by the light that passes through the masking element in the transparent regions.

The cylinder and the plate are of course made of transparent material.

The ultraviolet rays, by passing through the transparent regions of the masking element, sensitize the previously spread light-sensitive lacquer.

In this manner graphic markings are imprinted, by removing parts of the lacquer, which correspond to the non-transparent portions of the masking element, so that the graphic markings are printed with separations and without any deformation and with miniaturization characteristics that cannot be attained by means of conventional printing processes.

The resulting substrate with the graphic markings printed thereon can be used in many fields of application, ranging from security strips for currency bills, passports and the like to credit cards with miniaturized demetallized regions applied thereto, to food packages in which the miniaturization can be used and detected with low-cost and easily available instruments.

The provision of high-definition graphic markings of the above type has a high value in preventing forgery and counterfeiting.

It is of course possible to use a pigmented light-sensitive material, so as to provide colored characters.

In practice, therefore, the characters are formed at the areas in which the light-sensitive lacquer changes state due to the presence of the masking element, which is not transparent in said regions and therefore does not allow the ultraviolet rays to pass.

Thus, for example, the steps for vacuum metallization and demetallization might not be performed and the layer of light-sensitive lacquer might be pigmented and used as printing ink, allowing continuous miniaturized character printing.

In any case, the portions of light-sensitive lacquer that are not removed (i.e., remain anchored to the substrate) constitute a protective barrier against subsequent treatments (demetallization processes and others).

The method according to the invention can also be applied to fields other than the production of security strips. For example, it can be used to produce printed circuits.

All the steps of the method and the details may further be replaced with other technically equivalent steps and elements.

Where technical features mentioned in any claim are followed by reference signs, those reference signs have been included for the sole purpose of increasing the intelligibility of the claims and accordingly, such reference signs do not have any limiting effect on the interpretation of each element identified by way of example by such reference signs.

## Claims

1. A high-definition printing method, particularly for security strips for currency bills and the like, comprising the steps of:
preparing a substrate in tape form;
continuously depositing a layer of light-sensitive lacquer on said substrate;
applying a masking element to said layer of light-sensitive lacquer, said masking element being transparent at areas in which said lacquer is meant to change state by continuous exposure to ultraviolet rays; and
removing portions of lacquer that have not changed state from areas of said substrate that correspond to non-transparent portions of said masking element, the portions of lacquer that have changed state constituting a protective barrier for subsequent processes for forming high-definition miniaturized characters;
**characterized in that**
said masking element is arranged on a transparent cylinder onto which said substrate is unwound continuously.

2. A high-definition printing method, particularly for security strips for currency bills and the like, comprising the steps of:
preparing a substrate;
depositing a metallization layer on said substrate;
depositing a layer of light-sensitive lacquer on said metalization layer;
applying a masking element to said layer of light-sensitive lacquer, said masking element being transparent at areas in which said lacquer is meant to change state by exposure to ultraviolet rays;
removing portions of lacquer that have not changed state from areas of said substrate that correspond to non-transparent portions of said masking element, the portions of lacquer that have changed state constituting a protective barrier for subsequent processes for forming high-definition miniaturized characters; and
removing said metallization layer from said substrate;
**characterized in that**
said masking element is arranged on a transparent cylinder onto which said substrate is unwound continuously.

3. The method according to claim 1 or 2, **characterized in that** said light-sensitive lacquer is pigmented.

4. The method according to claim 2, **characterized in that** said substrate is optically transparent.

5. The method according to one or more of the preceding claims, **characterized in that** said light-sensitive lacquer is a solvent-based lacquer having characteristics that provide filming and adhesion to said substrate after evaporation.

6. The method according to one or more of the preceding claims, **characterized in that** said step that consists in removing portions of said lacquer that have not changed state comprises the steps of:
treating said substrate with a solution of sodium carbonate; and
washing said substrate in water and drying it.

7. The method according to claim 6, **characterized in that** said sodium carbonate solution is in a percentage between 0.4 and 2%.

8. The method according to claim 7, **characterized in that** said sodium carbonate solution is in a percentage of 0.7%.

9. The method according to claim 6, **characterized in that** it further comprises the steps of:
introducing said film in a tank with a phosphoric acid bath;
washing said substrate in demineralized water;
immersing said substrate in a bath of water and ammonia in order to buffer the effect of said phosphoric acid; and
washing said substrate with demineralized water again.

10. The method according to one or more of the preceding claims, **characterized in that** said masking element is of the negative type.

11. The method according to one or more of the preceding claims, **characterized in that** said masking element is of the positive type.

12. The method according to one or more of the preceding claims, **characterized in that** said masking element is arranged on a transparent plate which is adapted to be pressed against said substrate.

13. The method according to claim 11, **characterized in that** said transparent cylinder is internally provided with at least one ultraviolet lamp.

14. The method according to claim 11, **characterized in that** at least one ultraviolet lamp is arranged below said plate.

15. The method according to one or more of the preceding claims, **characterized in that** said phosphoric acid bath is a 30-70% bath at a temperature of 30-80°C.

16. The method according to one or more of the preceding claims,
**characterized in that** said substrate is immersed in said phosphoric acid bath for a time varying between 3 seconds and over 1 minute.

17. A document, **characterized in that** it internally comprises a security strip produced with the method according to claim 1.

18. A document, **characterized in that** it internally comprises a security strip produced with the method according to claim 2.

## Patentansprüche

1. Hochdefinitions-Druckverfahren, das insbesondere für Sicherheitsstreifen für Geldscheine und Ähnliches gedacht ist, das folgende Schritte umfasst:
Herstellung eines Substrats in der Form eines Bandes ;
kontinuierliches Ablagern einer Schicht aus einem lichtempfindlichen Lack auf dem genannten Substrat ;
Anwendung eines Maskierungselements auf die genannte Schicht aus einem lichtempfindlichen Lack, wobei das genannte Maskierungselement in den Feldern transparent ist, in denen der genannte Lack den Zustand auf Grund der kontinuierlichen Belichtung mit ultravioletten Strahlen ändern soll;
Entfernen der Teile des Lacks, die keinen geänderten Zustand aufweisen von Feldern, die den nicht transparenten Teilen des genannten Maskierungselements entsprechen, wobei die Teile des Lacks, die ihren Zustand geändert haben, eine Schutzbarriere gegenüber den folgenden Verfahren zur Bildung von in hohem Masse definierten Zeichen darstellen ;
**dadurch gekennzeichnet, dass** das genannte Maskierungselement auf einem transparenten Zylinder angeordnet ist, auf dem das genannte Substrat auf kontinuierliche Weise abgewickelt worden ist.

2. Hochdefinitions-Druckverfahren, das insbesondere für Sicherheitsstreifen für Geldscheine und Ähnliches gedacht ist, das folgende Schritte umfasst:
Herstellung eines Substrats;
Ablagern einer Metallisierungsschicht auf dem genannten Substrat;
Ablagern eines lichtempfindlichen Lacks auf die Metallisierungsschicht;
Anwendung eines Maskierungselements auf die genannte Schicht aus einem lichtempfindlichen Lack, wobei das genannte Maskierungselement in den Feldern transparent ist, in denen der Lack den genannten den Zustand auf Grund der Belichtung mit ultravioletten Strahlen ändern soll;
Entfernen der Teile des Lacks, die keinen geänderten Zustand aufweisen von Feldern, die den nicht transparenten Teilen des genannten Maskierungselements entsprechen, wobei die Teile des Lacks, die ihren Zustand geändert haben, eine Schutzbarriere gegenüber den folgenden Verfahren zur Bildung von in hohem Masse definierten Zeichen darstellen; und
Entfernen der genannten Metallisierungsschicht von dem genannten Substrat;
**dadurch gekennzeichnet, dass** das genannte Maskierungselement auf einem transparenten Zylinder angeordnet ist, auf dem das genannte Substrat auf kontinuierliche Weise abgewickelt worden ist.

3. Das Verfahren nach dem Patentanspruch 1 oder 2, **dadurch gekennzeichnet, dass** der genannte lichtempfindliche Lack pigmentiert ist.

4. Das Verfahren nach dem Patentanspruch 2, **dadurch gekennzeichnet, dass** das genannte Substrat optisch transparent it.

5. Das Verfahren nach einem oder mehreren der vorstehenden Patentansprüche,
**dadurch gekennzeichnet, dass** der genannte lichtempfindliche Lack ein lösemittelbasierter Lack ist, der Kennzeichnen aufweist, die die Filmbildung und Haftung auf dem genannten Substrat nach der Bedampfung zur Verfügung stellen.

6. Das Verfahren nach einem oder mehreren der vorstehenden Patentansprüche,
**dadurch gekennzeichnet, dass** der genannte Schritt, der daraus besteht, dass Teile des genannten Lacks entfernt werden, die nicht ihren Zustand geändert haben, folgenden Schritte umfasst :
Behandlung des genannten Substrats mit einer Lösung aus Natriumkarbonat; und
Waschen des genannten Substrats in Wasser und Trocknen des genannten Substrats.

7. Das Verfahren nach dem Patentanspruch 6, **dadurch gekennzeichnet, dass** die genannte Natriumkarbonatlösung einen Prozentsatz zwischen 0,4 und 2 % aufweist.

8. Das Verfahren nach dem Patentanspruch 7, **dadurch gekennzeichnet, dass** die genannten Natriumkarbonatlösung einen Prozentsatz von 0,7 % aufweist.

9. Das Verfahren nach dem Patentanspruch 6, **dadurch gekennzeichnet, dass** es außerdem die folgenden Schritte umfasst:
Einführen des genannten Films in ein Phosphorsäurebad ;
Waschen des genannten Substrats in entmineralisiertem Wasser ;
Eintauchen des genannten Substrats in ein Bald aus Wasser und Ammoniak, um die Wirkung der genannten Phosphorsäure zu puffern ; und
erneutes Waschen des genannten Substrats mit entmineralisiertem Wasser.

10. Das Verfahren nach einem oder mehreren der vorstehenden Patentansprüche,
**dadurch gekennzeichnet, dass** das genannte Maskierungselement vom negativen Typ ist.

11. Das Verfahren nach einem oder mehreren der vorstehenden Patentansprüche,
**dadurch gekennzeichnet, dass** das genannte Maskierungselement vom positiven Typ ist.

12. Das Verfahren nach einem oder mehreren der vorstehenden Patentansprüche,
**dadurch gekennzeichnet, dass** das genannte Maskierungselement auf einer transparenten Platte angeordnet ist, die dazu angepasst ist, gegen das genannte Substrat gepresst zu werden.

13. Das Verfahren nach dem Patentanspruch 11, **dadurch gekennzeichnet, dass** der genannte transparente Zylinder innen mit mindestens einer Ultraviolettlampe ausgerüstet ist.

14. Das Verfahren nach dem Patentanspruch 11 , **dadurch gekennzeichnet, dass** mindestens eine Ultraviolettlampe unter der genannten Platte angeordnet ist.

15. Das Verfahren nach einem oder mehreren der vorstehenden Patentansprüche,
**dadurch gekennzeichnet, dass** das genannte Phosphorsäurebad ein 30 - 70 % - Bad mit einer Temperatur zwischen 30 und 80 °C ist.

16. Das Verfahren nach einem oder mehreren der vorstehenden Patentansprüche,
**dadurch gekennzeichnet, dass** das genannte Substrat in das genannte Phosphorsäurebad während einer Zeit, die zwischen 3 Sekunden und 1 Minute variiert, eingetaucht wird.

17. Ein Dokument **dadurch gekennzeichnet, dass** es intern einen Sicherheitsstreifen umfasst, der mit Hilfe des Verfahrens nach dem Patentanspruch 1 produziert worden ist.

18. Ein Dokument **dadurch gekennzeichnet, dass** es intern einen Sicherheitsstreifen umfasst, der mit Hilfe des Verfahrens nach dem Patentanspruch 2 produziert worden ist.

## Revendications

1. Procédé d'impression haute définition, en particulier pour des bandes de détection pour papier-monnaie et similaires, comprenant les étapes consistant à :
préparer un substrat sous forme de bande ;
déposer en continu une couche de laque sensible à la lumière sur ledit substrat ;
appliquer un élément de masquage à ladite couche de laque sensible à la lumière, ledit élément de masquage étant transparent dans des zones dans lesquelles ladite laque est censée changer d'état par exposition continue à des rayons ultraviolets ; et
éliminer les parties de laque qui n'ont pas changé d'état des zones dudit substrat qui correspondent à des parties non transparentes dudit élément de masquage, les parties de laque qui ont changé d'état constituant une barrière protectrice pour des procédés ultérieurs de formation de caractères miniaturisés haute définition ;
**caractérisé en ce que**
ledit élément de masquage est agencé sur un cylindre transparent sur lequel est déroulé en continu ledit substrat.

2. Procédé d'impression haute définition, en particulier pour des bandes de détection pour papier-monnaie et similaires, comprenant les étapes consistant à :
préparer un substrat ;
déposer une couche de métallisation sur ledit substrat ;
déposer une couche de laque sensible à la lumière sur ladite couche de métallisation ;
appliquer un élément de masquage à ladite couche de laque sensible à la lumière, ledit élément de masquage étant transparent dans des zones dans lesquelles ladite laque est censée changer d'état par exposition à des rayons ultraviolets ;
éliminer les parties de laque qui n'ont pas changé d'état des zones dudit substrat qui correspondent à des parties non transparentes dudit élément de masquage, les parties de laque qui ont changé d'état constituant une barrière protectrice pour des procédés ultérieurs de formation de caractères miniaturisés haute définition ; et
retirer ladite couche de métallisation dudit substrat ;
**caractérisé en ce que**
ledit élément de masquage est agencé sur un cylindre transparent sur lequel est déroulé en continu ledit substrat.

3. Procédé selon la revendication 1 ou 2, **caractérisé en ce que** ladite laque sensible à la lumière est pigmentée.

4. Procédé selon la revendication 2, **caractérisé en ce que** ledit substrat est optiquement transparent.

5. Procédé selon une ou plusieurs des revendications précédentes, **caractérisé en ce que** ladite laque sensible à la lumière est une laque à base de solvant ayant des caractéristiques qui permettent la formation de film et l'adhérence audit substrat après évaporation.

6. Procédé selon une ou plusieurs des revendications précédentes, **caractérisé en ce que** ladite étape qui consiste à éliminer des parties de ladite laque qui n'ont pas changé d'état comprend les étapes consistant à :
traiter ledit substrat avec une solution de carbonate de sodium ; et
laver ledit substrat dans l'eau et le sécher.

7. Procédé selon la revendication 6, **caractérisé en ce que** ladite solution de carbonate de sodium est dans un pourcentage compris entre 0,4 et 2 %.

8. Procédé selon la revendication 7, **caractérisé en ce que** ladite solution de carbonate de sodium est dans un pourcentage de 0,7 %.

9. Procédé selon la revendication 6, **caractérisé en ce qu'**il comprend en outre les étapes consistant à :
introduire ledit film dans un réservoir avec un bain d'acide phosphorique ;
laver ledit substrat dans de l'eau déminéralisée ;
immerger ledit substrat dans un bain d'eau et d'ammoniaque afin de tamponner l'effet dudit acide phosphorique ; et
laver de nouveau ledit substrat avec de l'eau déminéralisée.

10. Procédé selon, une ou plusieurs des revendications précédentes, **caractérisé en ce que** ledit élément de masquage est de type négatif.

11. Procédé selon une ou plusieurs des revendications précédentes, **caractérisé en ce que** ledit élément de masquage est de type positif.

12. Procédé selon une ou plusieurs des revendications précédentes, **caractérisé en ce que** ledit élément de masquage est agencé sur une plaque transparente qui est adaptée pour être pressée contre ledit substrat.

13. Procédé selon la revendication 11, **caractérisé en ce que** ledit cylindre transparent est équipé de manière interne d'au moins une lampe ultraviolette.

14. Procédé selon la revendication 11, **caractérisé en ce qu'**au moins une lampe ultraviolette est agencée sous ladite plaque.

15. Procédé selon une ou plusieurs des revendications précédentes, **caractérisé en ce que** ledit bain d'acide phosphorique est un bain à 30 à 70 % à une température de 30 à 80°C.

16. Procédé selon une ou plusieurs des revendications précédentes, **caractérisé en ce que** ledit substrat est immergé dans ledit bain d'acide phosphorique pendant une durée variant entre 3 secondes et plus de 1 minute.

17. Document, **caractérisé en ce qu'**il comprend de manière interne une bande de détection produite avec le procédé selon la revendication 1.

18. Document, **caractérisé en ce qu'**il comprend de manière interne une bande de détection produite avec le procédé selon la revendication 2.
